(19) Europäisches Patentamt
European Patent Office
Office européen des brevets

(11) **EP 2 933 846 A1**

(12) **EUROPEAN PATENT APPLICATION**
published in accordance with Art. 153(4) EPC

(43) Date of publication:
**21.10.2015 Bulletin 2015/43**

(21) Application number: **13863342.5**

(22) Date of filing: **12.10.2013**

(51) Int Cl.:
*H01L 31/18* (2006.01)     *H01L 31/052* (2014.01)
*H01L 31/0224* (2006.01)     *G02B 3/00* (2006.01)

(86) International application number:
**PCT/CN2013/085139**

(87) International publication number:
**WO 2014/090036 (19.06.2014 Gazette 2014/25)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **12.12.2012 CN 201210534148**
**19.03.2013 CN 201310086392**
**19.03.2013 CN 201310086729**

(71) Applicant: **Si Chuan Zhong Shun Solar Energy Development Co., Ltd.**
**Chengdu, Sichuan 610207 (CN)**

(72) Inventor: **HUANG, Zhong**
**Chengdu**
**Sichuan 610207 (CN)**

(74) Representative: **Machtalère, Georges et al**
**Office Kirkpatrick S.A.**
**Avenue Wolfers, 32**
**1310 La Hulpe (BE)**

(54) **LINEAR CONDENSATION ASSEMBLY AND MANUFACTURING PROCESS THEREFOR**

(57) Provided are a linear condensation assembly and a manufacturing process therefor. The linear condensation assembly comprises a linear condensation glass panel, a sealing material layer, a solar cell and a back panel. The manufacturing process comprises: testing cell pieces in a grading manner; cutting the cell pieces; welding strip-shaped cells; and serially welding, stacking, inspecting and testing grid cell pieces (21). By adding scribing, segmenting and welding processes for processing common crystalline silicon solar cell pieces, common crystalline silicon solar cells are made to form grid cell pieces composed of strip-shaped solar cells which are arranged at certain fixed intervals, and mate with a special linear condensation glass panel to be subjected to subsequent stacking and laminating and curing processes so as to finally obtain a photovoltaic assembly. A linear condensation photovoltaic assembly manufactured by the process can effectively reduce the consumption of cell pieces as compared with a common photovoltaic assembly, thereby reducing the manufacturing cost of the photovoltaic assembly.

Figure 9

**Description**

**Field of the Invention**

The invention belongs to the technical field of solar utilization, in particular to a linear condensation assembly and a manufacturing process thereof.

**Description of the Related Art**

Solar energy is becoming more and more popular as it is clean, has no geographic limit, and is inexhaustible for human beings. Solar photovoltaic utilization (i.e. technology of directly converting sunlight into electric power through photovoltaic devices) is especially striking. At present, the manufacturing process of a photovoltaic solar cell module comprises grading testing of common crystalline silicon solar cell pieces, single welding and series welding of the cell pieces, stacking, lamination and curing, and assembly of an aluminum alloy frame. As the crystalline silicon solar cell pieces used in the whole process have high price and large consumption, the final photovoltaic solar cell module product has high cost, so that the cost of the photovoltaic power generation at current stage is several times greater than that of the conventional power generation, thus limiting large-scale application of photovoltaic power generation technology and restricting development of the entire industry.

**Summary of the Invention**

The purpose of the invention is to provide a linear condensation assembly capable of effectively reducing consumption of cell piece of a common photovoltaic module and further reducing production cost of the photovoltaic module as well as a manufacturing process thereof.

The technical solution of the invention is realized by a manufacturing process of a linear condensation assembly characterized by comprising the following processing steps:

a) grading testing of cell pieces: grading power graded cell pieces based on the current value at the maximum power output thereof;

b) cutting of the cell pieces: cutting crystalline silicon solar cells along the direction perpendicular to main grid lines of the cell pieces by laser or diamond to form strip-shaped solar cells;

c) welding of the strip-shaped solar cells: arranging multiple solar cells cut into strips at certain intervals, and electrically connecting the solar cells by solder strips to form grid solar cell pieces;

d) series welding of the grid solar cell pieces: arranging multiple grid solar cell pieces formed in the step c) at certain intervals and welding the cell pieces to form cell strings;

e) stacking: successively stacking a linear condensation glass panel, a cell sealing material, the cell strings, the cell sealing material and a back panel material, and electrically connecting the cell strings of different grid shapes by a busbar; and

f) inspection and testing: visually inspecting the stacked linear condensation assembly, then carrying out EL testing, and finally carrying out subsequent procedures.

For the manufacturing process of a linear condensation assembly of the invention, in the step b), the cutting of the solar cells is divided into scribing and segmenting, the solar cells are scribed by laser or diamond to form 50 to 150µm depth on the solar cells, and then the solar cells are segmented along scribing positions by a segmenting device to form strip-shaped solar cells.

For the manufacturing process of a linear condensation assembly of the invention, in the step b), the back of the solar cells is scribed by laser or diamond, and then the solar cells are segmented along cutting positions by a segmenting device to form the strip-shaped solar cells.

In the manufacturing process of a linear condensation assembly of the invention, the solar cell cut at a certain depth is placed on a soft rubber pad, with the side of the solar cell with scribing incision facing downward and the other side being provided with a layer of protective film; a scrollable rigid roller is placed on the protective film, and the rigid roller rolls along the direction perpendicular to the scribing direction of the solar cell; and the solar cell pieces are rolled by the rigid roller and disconnected from the incision to form strip-shaped solar cells, and after the solar cell pieces are disconnected into strip-shaped solar cells, the protective film on the front of the solar cell is removed, and the strip-shaped solar cells are placed at certain intervals by a strip-shaped solar cell pickup device.

In the manufacturing process of a linear condensation assembly of the invention, the solar cell cut at a certain depth is placed on a cell fixing platform with the back facing up, and fixed and adsorbed by negative pressure; a pneumatic clamping gripper arranged at the cell fixing platform clamps one side of the solar cell and inches the solar cell at a certain beat under the action of an inching drive mechanism; the other side of the solar cell is clamped at the clamping position of a segmenting mechanism, and the clamping position acts downward under the action of a segmenting cylinder to disconnect the solar cell along the scribing position and complete segmenting of the solar cell pieces; and the segmented strip-shaped solar cells are placed at certain intervals by the clamping position of the segmenting mechanism through a step motor.

In the manufacturing process of a linear condensation assembly of the invention, in the step c), firstly, lower solder strips with the same number as the main grid lines of the welded strip-shaped solar cells are placed in a solder strip placement slot on a grid solar cell piece welding platform, vacuum adsorption holes arranged in the solder strip placement slot correspond to the lower solder strips, and the lower solder strips are fixed by adsorption; secondly, the strip-shaped solar cells cut as per the step b) are placed on the grid solar cell piece welding platform at a certain fixed interval, the upper end faces of the lower solder strips contact positive poles of corresponding strip-shaped solar cells, the vacuum adsorption holes on the grid solar cell piece welding platform correspond to the placed strip-shaped solar cells, and the strip-shaped solar cells are fixed by adsorption; thirdly, upper solder strips are placed on negative main grid lines corresponding to the strip-shaped solar cells, an upper fire resistant hold-down mechanism moves downwards, and hold-down strips of the hold-down mechanism are used to compress the upper solder strips and the strip-shaped solar cells to allow close fit of the upper and lower solder strips and the strip-shaped solar cells during welding; and finally, an infrared soldering lamp moves downwards for infrared heating welding of welding positions of the solder strips and the strip-shaped solar cells through square holes arranged at the hold-down strips to form grid solar cell pieces, for the grid solar cell pieces made by the welding method, the strip-shaped solar cells are interconnected in parallel, i.e. a positive pole is connected to a positive pole and a negative pole is connected to a negative pole.

In the manufacturing process of a linear condensation assembly of the invention, in the step e), the linear condensation glass panel is properly placed, and a layer of cell sealing material is applied on the linear condensation glass panel, then the cell strings are placed, and a positioning device is used to align centers of the strip-shaped solar cells of the cell strings with optical construction centers of all curved linear condensation surfaces on the linear condensation glass panel, after alignment, a layer of cell sealing material and a layer of back panel material are successively applied.

In the manufacturing process of a linear condensation assembly of the invention, the optical construction centers of the curved linear condensation surfaces on the linear condensation glass panel are identified by two position sensors, the position sensors move along optical structure surfaces of the curved linear condensation surfaces of the linear condensation glass panel to judge the highest points of the curved linear condensation surfaces, and then judge the center lines of the curved linear condensation surfaces, the strip-shaped solar cells move back and forth or left to right or rotate through strip-shaped cell position moving devices, and the strip-shaped cell position moving devices move accordingly based on central positions of the curved linear condensation surfaces of the linear condensation glass panel identified by the position sensors and deviation values to correct positions of the strip-shaped solar cells so that the centers are aligned with the optical construction centers of the curved linear condensation surfaces of the linear condensation glass panel.

In the manufacturing process of a linear condensation assembly of the invention, the linear condensation glass panel gathers and projects solar rays received on the cell strings, width of linear condensing rays formed after the curved linear condensation surfaces of the linear condensation glass panel gather solar rays is not more than width of the strip-shaped solar cells in the cell strings, or the width of the linear condensing rays formed after the curved linear condensation surfaces of the linear condensation glass panel gather solar rays is not less than the width of the strip-shaped solar cells in the cell strings.

In the manufacturing process of a linear condensation assembly of the invention, the width of linear condensing rays formed after the curved linear condensation surfaces of the linear condensation glass panel gather solar rays is consistent with the width of the strip-shaped solar cells in the cell strings, and the spacing between the two adjacent strip-shaped solar cells is consistent with the spacing between the linear condensing rays formed by adjacent curved linear condensation surfaces.

In the manufacturing process of a linear condensation assembly of the invention, receiving surfaces on upper surfaces of the strip-shaped solar cells of the grid solar cell pieces are on the same plane, the receiving surfaces formed by upper surfaces of the grid solar cell pieces in the cell strings are on the same plane, and the receiving surfaces formed by upper surfaces of the cell strings are on the same plane.

A linear condensation assembly comprises a linear condensation glass panel, a sealing material layer, solar cells and a back panel; the upper part of the condensation glass panel is of a curved linear arc-shaped condensation surface array; the solar cells comprise multiple strip-shaped solar cells and solders strips; the strip-shaped solar cells vertically correspond to curved linear arc-shaped condensation surfaces of the linear condensation glass panel; the multiple strip-shaped solar cells are welded and connected on the solder strips to form grid solar cell pieces; and the linear condensation glass panel, the sealing material layer, the solar cells and the back panel are laminated to form a linear condensation assembly.

For the linear condensation assembly of the invention, an upper end surface of the linear condensation glass panel is lens condensing and refracting surface, and a lower end thereof is a flat surface; the lens extends transversally and is of strip shape, the linear condensation glass panel is capable of refracting mutually parallel incident rays onto the grid solar cell pieces arranged below the linear condensation glass panel so as to form linear condensation rays; if the vertical distance from the contact point between any incident ray and the lens condensing and refracting surface to the corresponding lens vertical central axis on the linear condensation glass panel is x, the vertical distance from a projection point formed after the incident ray is refracted onto a corresponding strip-shaped solar cell through the lens to the center line in the length direction of the linear condensation ray is m, the vertical distance from the edge of the lens condensing and refracting surface to the vertical central axis is a, and the vertical distance from the projection point of the incident ray refracted through the edge of the lens condensing and refracting surface on the strip-shaped solar cell to the center line in the length direction of the linear condensation ray is b, the condition that the lens meets is x/m=a/b, where, a vertical surface composed of an incidence point of the incident ray and two edges of the lens condensing and refracting surface is perpendicular to the center line in the length direction of the linear condensation ray; the upper part of the vertical surface is the contour shape of the lens condensing and refracting surface, an incidence angle at which the incident ray passes through the lens condensing and refracting surface is $\beta$, and a refraction angle is $\theta$, an included angle between the incident ray refracted and the strip-shaped solar cell is $\alpha$, the vertical distance from the lens condensing and refracting surface to the strip-shaped solar cell is h; in the vertical surface, a plane coordinate system is composed of the vertical central axis and a connecting line between two edges of the lens condensing and refracting surface; and with the middle point of the connecting line between two edges of the lens condensing and refracting surface as the origin of coordinate, the curve equation of the contour shape of the lens condensing and refracting surface on the vertical surface in the plane coordinate system is obtained from the following formulas:

$$\text{Formula 1: } x/m = a/b, \quad x = a - N * \triangle x,$$

where $\triangle x$ is a very small distance in the direction of X axis, and N is the number of the small intervals;

$$\text{Formula 2: } y_n = y_{n-1} + \triangle x * \tan \beta;$$

$$\text{Formula 3: } \tan \alpha = (h + y_n) / (a - m), \quad m = b - N * \triangle x * b/a;$$

$$\text{Formula 4: } \sin \beta = n * \sin\theta,$$

where coefficient n is refractive index of the lens;

$$\text{Formula 5: } \alpha - \theta + \beta = \pi/2,$$

that is, $\theta = (\alpha + \beta) - \pi/2$;

$$\text{Formula 6: } \sin \beta = n * \sin[(\alpha + \beta) - \pi/2] = n * [-\cos(\alpha + \beta)] = n * (\sin \alpha * \sin \beta - \cos \alpha * \cos \beta);$$

$$\text{Formula 7: } \tan \beta = n * \cos \alpha / (n * \sin \alpha - 1);$$

Where, a, b, h, n and $\triangle x$ are known, and $y_0$ is equal to 0; variable x is the transversal distance from any point on the lens condensing and refracting surface to the vertical central axis on the vertical surface, and variable y is the vertical distance from the point to the plane where both edges of the lens condensing and refracting surface are located.

For the linear condensation assembly of the invention, the contour shape of the lens condensing and refracting surface on the vertical surface is a polygon, as value of $\Delta x$ decreases, the edges of the polygon of the lens condensing and refracting surface increase till a smooth curved linear arc-shaped condensation surface is formed, where condition that $\Delta x$ shall meet is $a/\Delta x = M$, M is any integer, and $2000 < a/\Delta x < 10000$.

For the linear condensation assembly of the invention, the vertical distance a from the edge of the lens condensing and refracting surface to the vertical central axis and the vertical distance b from the projection point of the incident ray refracted through the lens condensing and refracting surface on the strip-shaped solar cell to the center line in the length direction of the linear condensation ray meet the following condition: $1 < a/b \leq 10$.

For the linear condensation assembly of the invention, the vertical distance from the edge of the lens condensing and refracting surface to the lower flat surface below the linear condensation glass panel is h, and the lower end surface of the linear condensation glass panel is accordingly connected with the upper end surface of the strip-shaped solar cell.

For the linear condensation assembly of the invention, the linear condensation glass panel is symmetrical or asymmetrical along the vertical central axis.

For the linear condensation assembly of the invention, the surface of the solar cell comprises multiple annular fine grid lines equally spaced on the solar cell and at least two main grid lines perpendicular to the annular fine grid lines, the spacing between two adjacent annular fine grid lines is 0.1mm to 2mm, and each annual fine grid line is 1mm to 10mm wide.

For the linear condensation assembly of the invention, the main grid lines are disconnected at the clearance between two adjacent annular fine grid lines, and are divided into multiple separate units matched with the annular fine grid lines.

For the linear condensation assembly of the invention, the scribing position is at the clearance between the two adjacent annular fine grid lines; the width of the annular fine grid line is less than that of cut strip-shaped solar cells. each annular fine grid line corresponds to a strip-shaped solar cell, and the annular fine grid lines are uniformly distributed at edges of corresponding strip-shaped solar cells.

For the linear condensation assembly of the invention, the annular fine grid lines close to left and right edges on the solar cell are of the same design and symmetrically arranged, and the annular fine grid lines therebetween are of the same design and of rectangular shape.

For the linear condensation assembly of the invention, the grid solar cell pieces include multiple equally spaced strip-shaped solar cells, and the strip-shaped solar cells are electrically connected by solder strips composed of multiple solder strip sections connected between two adjacent strip-shaped solar cells, one end of each solder strip section is connected to the upper end of one strip-shaped solar cell, and the other end is connected to the lower end of the other strip-shaped solar cell connected thereto; and the solder strip sections are successively connected so that multiple strip-shaped solar cells are electrically connected in series.

For the linear condensation assembly of the invention, the solder strip sections are of Z shape.

In the invention, scribing, segmenting and welding processes for common crystalline silicon solar cell pieces are added in the manufacturing process so that common crystalline silicon solar cells can form grid solar cell pieces composed of strip-shaped solar cells at certain fixed interval, and then the grid solar cell pieces are subject to subsequent stacking, lamination and curing processes under the cooperation of a special linear condensation glass panel to obtain a photovoltaic module finally. The linear condensation photovoltaic module manufactured by the process of the invention can reduce consumption of cell piece of common photovoltaic module, thus reducing manufacturing cost of the photovoltaic module.

**Brief Description of the Drawings**

Figure 1 is an enlarged view of a side face of a scribed solar cell piece of the invention.

Figure 2 is a structural diagram of a segmenting device of the invention.

Figure 3 is a structural diagram of another segmenting device of the invention.

Figures 4 to 8 are structural diagrams of a welding fixture for a grid solar cell piece of the invention.

Figure 9 is a structural diagram of a grid solar cell piece of the invention.

Figure 10 is a structural diagram of a cell string of the invention.

Figure 11 shows a positioning device for aligning a linear condensation glass panel and all strip-shaped solar cells in the cell string.

Figure 12 is an alignment judgment and identification flow diagram.

Figure 13 is a local enlarged view of a linear condensation assembly.

Figure 14 is a structural diagram of a linear condensation glass panel.

Figures 15 and 16 are section contour diagrams of lens condensing and refracting surfaces obtained according to different values of $\Delta x$.

Figure 17 is a power distribution diagram of light spots after using a traditional lens as a condenser lens.

Figure 18 is a power distribution curve of light spots after using a traditional lens as a condenser lens.

Figure 19 is a power distribution diagram of light spots after using a linear condensation lens of the invention.

Figure 20 is a power distribution curve of light spots after using a linear condensation lens of the invention.

Figure 21 is design of main grid lines disconnected on the solar cell.

Figure 22 is a local enlarged view of Figure 21.

Figure 23 is a structural diagram of grid solar cell pieces of the invention connected in series.

Marks in figures are as follows: 1: linear condensation glass panel; 2: sealing material layer; 3: solar cell; 4: back panel; 6: strip-shaped solar cell; 7: solder strip; 8: incident ray; 9: vertical central axis; 10: annular fine grid line; 11: main grid line; 12: solder strip section; 13: soft rubber pad; 14: protective film; 15: rigid roller; 16: cell fixing platform; 17: pneumatic clamping gripper; 18: inching drive mechanism; 19: clamping position of segmenting mechanism; 20: segmenting cylinder; 21: grid solar cell piece; 22: grid solar cell piece welding platform; 23: solder strip placement slot; 24: vacuum adsorption hole; 25: hold-down mechanism; 26: hold-down strip; 27: infrared soldering lamp; 28: square hole; 29: cell string; 30: position sensor; 31: strip-shaped cell position moving device.

**Description of the Preferred Embodiment**

The invention will be described in detail in combination with accompanied drawings.
In order to make the purpose, technical solution and advantages of the invention more clear, the invention will be described in detail in combination with accompanied drawings and embodiments. It should be understood that various embodiments described herein are only used to explain the invention rather than defining the invention.
A manufacturing process of a linear condensation assembly comprises the following processing steps:

a) grading testing of cell pieces: grading power graded cell pieces based on the current value at the maximum power output thereof;

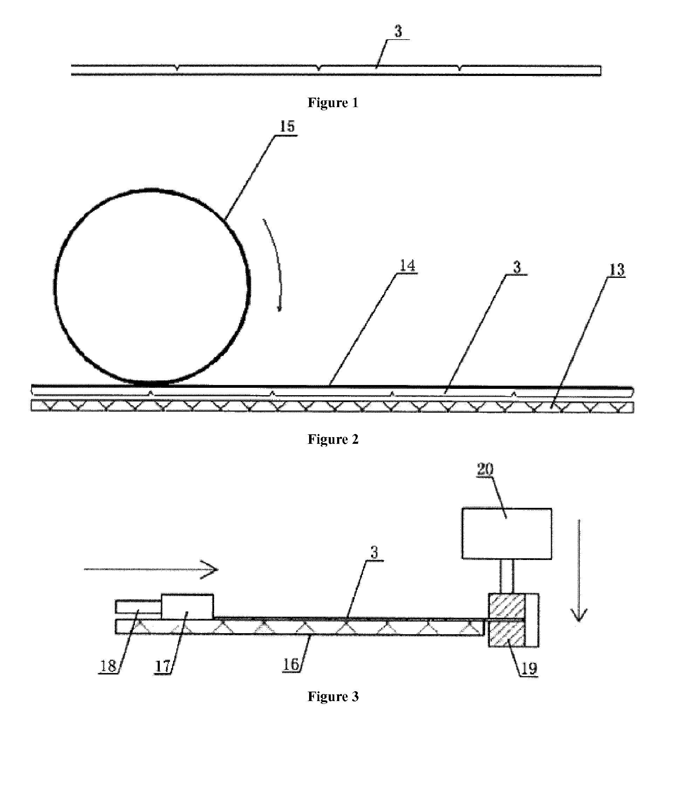

b) cutting of the cell pieces: cutting crystalline silicon solar cells along the direction perpendicular to main grid lines of the cell pieces by laser or diamond to form strip-shaped solar cells; wherein the cutting of the solar cells is divided into scribing and segmenting, as shown in Figure 1, the back of the solar cells is scribed by laser or diamond to form a 50 to 150 $\mu$m depth on the solar cells, the scribing position is between adjacent annular fine grid lines, and then the solar cells are segmented along scribing positions by a segmenting device to form the strip-shaped solar cells. As shown in Figure 2, the solar cell 3 cut at a certain depth is placed on a soft rubber pad 13, with the side of solar cell 3 with scribing incision facing downward and the other side being provided with a layer of protective film 14; a scrollable rigid roller 15 is placed on the protective film 14, and the rigid roller 15 rolls along the direction perpendicular to the scribing direction of the solar cell 3; and the solar cell pieces are rolled by the rigid roller and disconnected from the incision to form the strip-shaped solar cells. After the solar cell pieces are broken into the strip-shaped solar cells, the protective film on the front of the solar cell is removed, and strip-shaped solar cells are placed at certain intervals by a strip-shaped solar cell pickup device. Firstly, the back of the solar cell is cut at a certain depth, and the solar cell is subject to segmenting operation by a segmenting device, so that the cell is naturally broken from the cutting position, thus avoiding damage of the PN junction caused by laser or diamond cutter to the greatest extent and ensuring efficiency of the solar cell to some extent.

As another segmenting means shown in Figure 3, the solar cell 3 cut at a certain depth is placed on a cell fixing platform 16 with the back facing up, and fixed and absorbed by negative pressure; a pneumatic clamping gripper 17 arranged at the cell fixing platform 16 clamps one side of the solar cell 3 and inches the solar cell 3 at a certain beat under the action of an inching drive mechanism 18; the other side of the solar cell 3 is clamped at the clamping position 19 of the segmenting mechanism, and the clamping position 19 acts downward under the action of the segmenting cylinder 20 to disconnect the solar cell 3 along the scribing position and complete segmenting of the solar cell pieces; and the segmented strip-shaped solar cells 6 are placed at certain intervals by the clamping position 19 of the segmenting mechanism through a step motor.

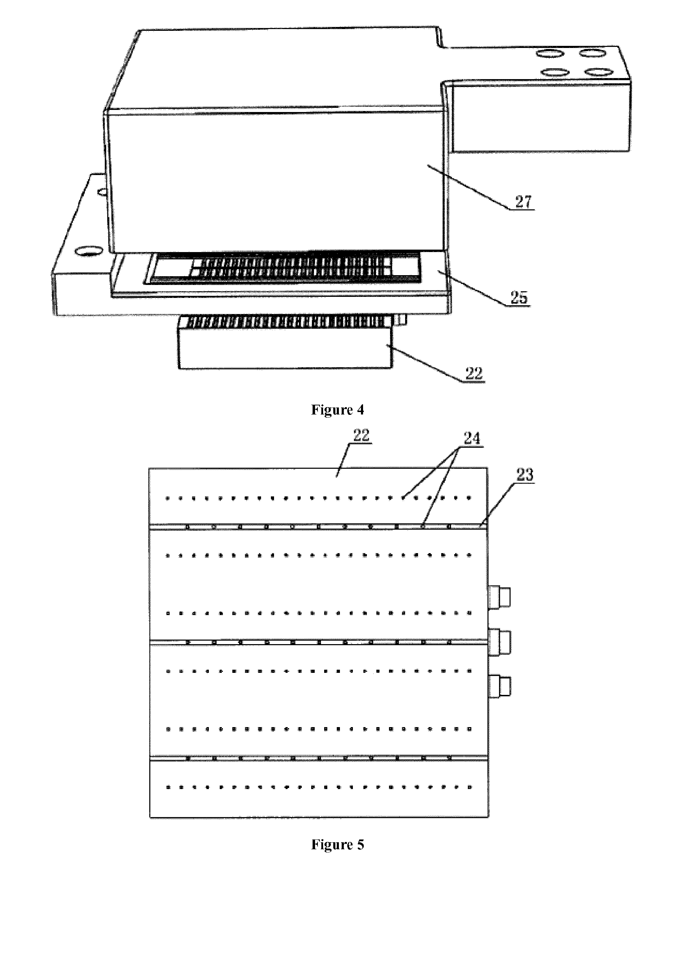

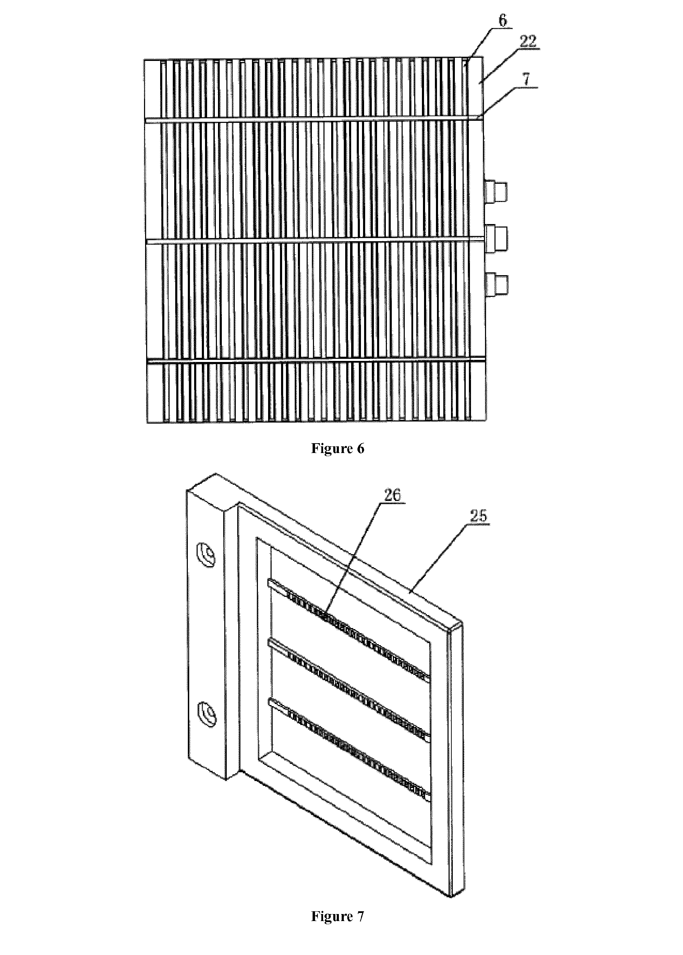

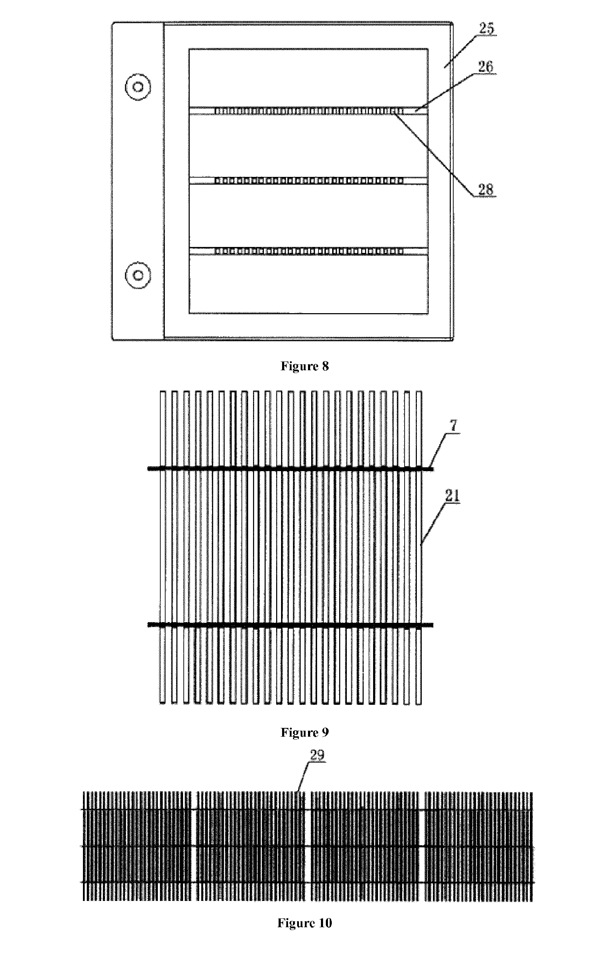

c) welding of the strip-shaped solar cells: arranging multiple solar cells cut into strips at certain intervals, and electrically connecting the solar cells by solder strips to form grid solar cell pieces 21, as shown in Figure 9. As shown in Figures 4 to 8, the specific welding process of the grid solar cell pieces is as follows: firstly, lower solder strips with the same number as the main grid lines 11 of the welded strip-shaped solar cells 6 are placed in a solder strip placement slot 23 on a grid solar cell piece welding platform 22, vacuum adsorption holes 24 arranged in the solder strip placement slot 23 correspond to the lower solder strips, and the lower solder strips are fixed by adsorption; secondly, the strip-shaped solar cells 6 cut as per the step b) are placed on the grid solar cell piece welding platform 22 at a certain fixed interval, the upper end face of the lower solder strips contacts positive pole of the corresponding strip-shaped solar cells 6, the vacuum adsorption hole 24 on the grid solar cell piece welding platform 22 corresponds to the placed strip-shaped solar cells 6, and the strip-shaped solar cells 6 are fixed by adsorption so that the solder strips 7 and the strip-shaped solar cells 6 placed on the grid solar cell piece welding platform 22 do not shift due to adsorption; wherein the depth of the solder strip placement slot 23 is not more than thickness of the solder strips 7, and preferably, the solder strips are slightly higher than the upper end face of the grid solar cell piece welding platform after the solder strips are placed in the solder strip placement slot, which is in favor of close fit of the solder strips and the strip-shaped solar cells; thirdly, upper solder strips are placed on negative main grid lines corresponding to the strip-shaped solar cells 6, an upper fire resistant hold-down mechanism 25 moves downwards, and hold-down strips 26 of the hold-down mechanism 25 compress the upper solder strips and the strip-shaped solar cells 6 to allow close fit of the upper and lower solder strips and the strip-shaped solar cells during welding, thus avoiding cold solder joints and solder skips; and finally, an infrared soldering lamp 27 moves downwards for infrared heating welding of the welding positions of the solder strips 7 and the strip-shaped solar cells 6 through square holes 28 arranged at the hold-down strips 26 to form the grid solar cell pieces 21. For the grid solar cell pieces made by the welding method, the strip-shaped solar cells are interconnected in parallel, i.e. a positive pole is connected to a positive pole and a negative pole is connected to a negative pole.

The solder strips and the strip-shaped solar cells are compressed by fitting the grid solar cell piece welding platform and the hold-down mechanism; and then the solder strips and the strip-shaped solar cells are welded by an infrared soldering lamp. The complete welding process realizes high automation and effectively solves problems in manual welding and existing automatic welding equipment.

d) series welding of the grid solar cell pieces 21: arranging multiple grid solar cell pieces 21 formed in the step c) at certain intervals and welding the cell pieces to form cell strings 29, as shown in Figure 10.

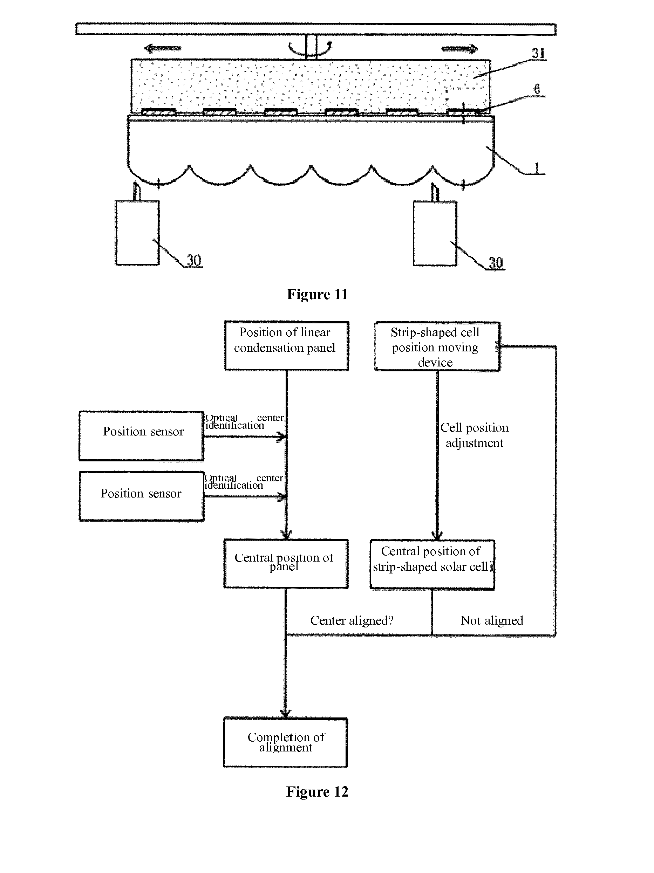

e) stacking: successively stacking a linear condensation glass panel, a cell sealing material, the cell strings, the cell sealing material and a back panel material, and electrically connecting the cell strings by a busbar; wherein, the linear condensation glass panel 1 is properly placed, and a layer of cell sealing material is applied on the linear condensation glass panel 1, then the cell strings 29 are placed, and a positioning device is used to align centers of the strip-shaped solar cells 6 of the cell strings 29 with optical construction centers of all curved linear condensation surfaces of the linear condensation glass panel 1, after alignment, a layer of cell sealing material and a layer of back panel material are successively applied. As shown in Figure 11, the optical construction centers of the curved linear condensation surfaces of the linear condensation glass panel 1 are identified by two position sensors 30, the position sensors 30 move along optical structure surfaces of the curved linear condensation surfaces of the linear condensation glass panel 1 to judge the highest points of the curved linear condensation surfaces, and then judge the center lines of the curved linear condensation surfaces, the strip-shaped solar cells 6 move back and forth or left to right or rotate through strip-shaped cell position moving devices 31, and the strip-shaped cell position moving devices 31 move accordingly based on central positions of the curved linear condensation surfaces of the linear condensation glass panel 1 identified by the position sensors 30 and deviation values to correct positions of the strip-shaped solar cells 6 so that the centers to be aligned with the optical construction centers of the curved linear condensation surfaces of the linear condensation glass panel 1.

The linear condensation glass panel 1 gathers and projects solar rays received on the cell strings 29, width of linear condensing rays formed after the curved linear condensation surfaces of the linear condensation glass panel 1 gather solar rays is not more than width of the strip-shaped solar cells 6 in the cell strings 29, or the width of linear condensing rays formed after the curved linear condensation surfaces of the linear condensation glass panel 1 gather solar rays is not less than the width of the strip-shaped solar cells 6 in the cell strings 29. In the example, the width of the linear condensing rays formed after the curved linear condensation surfaces of the linear condensation glass panel 1 gather solar rays is consistent with the width of the strip-shaped solar cells 6 in the cell strings 29, and the spacing between the two adjacent strip-shaped solar cells 6 is consistent with the spacing between the linear condensing rays formed by adjacent curved linear condensation surfaces; and the receiving surfaces on upper surfaces of the strip-shaped solar cells of the grid solar cell pieces are on the same plane, the receiving surfaces formed by upper surfaces of the grid solar cell pieces in the cell strings are on the same plane, and the receiving surfaces formed by upper surfaces of the cell strings are on the same plane. Figure 12 is a judgment and identification flow diagram of aligning the linear condensation glass panel 1 with the strip-shaped solar cells 6 in the cell strings 29.

f) inspection and testing: visually inspecting the stacked linear condensation assembly, then carrying out EL testing, and finally carrying out subsequent procedures.

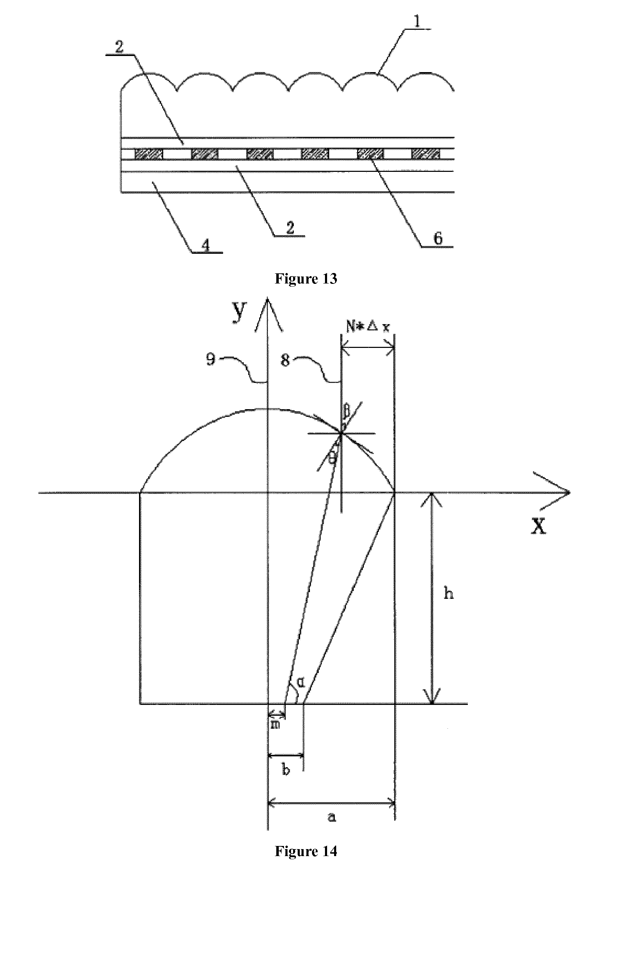

As shown in Figure 13, a linear condensation assembly comprises a linear condensation glass panel 1, a sealing material layer 2, solar cells 3 and a back panel 4; the upper part of the condensation glass panel 1 is of a curved linear arc-shaped condensation surface array, the solar cells 3 comprise multiple strip-shaped solar cells 6 and solder strips 7, the strip-shaped solar cells 6 vertically correspond to curved linear arc-shaped condensation surfaces of the linear condensation glass panel 1, the multiple strip-shaped solar cells 6 are welded and connected on the solder strips 7 to form grid solar cell pieces, and the linear condensation glass panel 1, the sealing material layer 2, the solar cells 3 and the back panel 4 are laminated to form a linear condensation assembly.

As shown in Figure 14, an upper end surface of the linear condensation glass panel 1 is a lens condensing and refracting surface, and a lower end thereof is level surface. The lens extends transversally and is of strip shape. The linear condensation glass panel 1 is capable of refracting mutually parallel incident rays onto the grid solar cell pieces arranged below the linear condensation glass panel 1 so as to form linear condensation rays. If the vertical distance from a contact point between any incident ray 8 and the lens condensing and refracting surface to corresponding vertical central axis 9 of the lens on the linear condensation glass panel 1 is x, the vertical distance from a projection point formed after the incident ray 8 is refracted onto the corresponding strip-shaped solar cell 6 through the lens to the center line in the length direction of the linear condensation ray is m, the vertical distance from the edge of the lens condensing and refracting surface to the vertical central axis 9 is a, and the vertical distance from the projection point of the incident ray refracted through the edge of the lens condensing and refracting surface on the strip-shaped solar cell 6 to the center line in the length direction of the linear condensation ray is b, the condition that the lens meets is x/m=a/b, wherein, a vertical surface composed of an incidence point of the incident ray 8 and two edges of the lens condensing and refracting surface is perpendicular to the center line in the length direction of the linear condensation ray. The upper part of the vertical surface is the contour shape of the lens condensing and refracting surface. An incidence angle at which the incident ray 8 passes through the lens condensing and refracting surface is $\beta$, and a refraction angle is $\theta$; an included angle between the incident ray 8 refracted and the strip-shaped solar cell 6 is $\alpha$, the vertical distance from the lens condensing and refracting surface to the strip-shaped solar cell 6 is h, in the vertical surface, a plane coordinate system is composed of the vertical central axis 9 and a connecting line between two edges of the lens condensing and refracting surface; and with the middle point of the connecting line between two edges of the lens condensing and refracting surface as the origin of coordinate, a curve equation of the contour shape of the lens condensing and refracting surface on the vertical surface in the plane-coordinate system is obtained from the following formulas:

$$\text{Formula 1: } x/m=a/b, \quad x=a-N*\triangle x,$$

where $\triangle x$ is a very small distance in the direction of X axis, and N is the number of the small intervals;

$$\text{Formula 2: } y_n=y_{n-1}+\triangle x*\tan \beta;$$

Formula 3: $\tan \alpha = (h+y_n) / (a-m)$, $m=b-N*\triangle x*b/a$;

Formula 4: $\sin \beta=n*\sin\theta$, where coefficient n is refractive index of the lens;

Formula 5: $\alpha-\theta+\beta= \pi/2$, that is, $\theta = (\alpha+\beta) -\pi/2$;

Formula 6: $\sin \beta=n*\sin[ (\alpha+\beta) -\pi/2]= n*[-\cos (\alpha+\beta) ]=n* (\sin \alpha*\sin \beta-\cos \alpha*\cos \beta)$;

Formula 7: $\tan \beta=n*\cos \alpha/ (n*\sin \alpha-1)$;

Where, a, b, h, n and $\triangle x$ are known, and $y_0$ is equal to 0; variable x is the transversal distance from any point on the lens condensing and refracting surface to the vertical central axis 9 on the vertical surface, and variable y is the vertical distance from the point to the plane where both edges of the lens condensing and refracting surface are located.

The vertical distance a from the edge of the lens condensing and refracting surface to the vertical central axis 9 and the vertical distance b from the projection point of the incident ray 8 refracted through the lens condensing and refracting surface on the strip-shaped solar cell 6 to the central line in the length direction of the linear condensation ray meet the following condition: $1<a/b\leq10$ is preferred, but it is a preferred value rather than a compulsory condition.

The contour shape of the lens condensing and refracting surface on the vertical surface is a polygon. As value of $\triangle x$ decreases, the edges of the polygon of the lens condensing and refracting surface increase till a smooth curved linear arc-shaped condensation surface is formed.

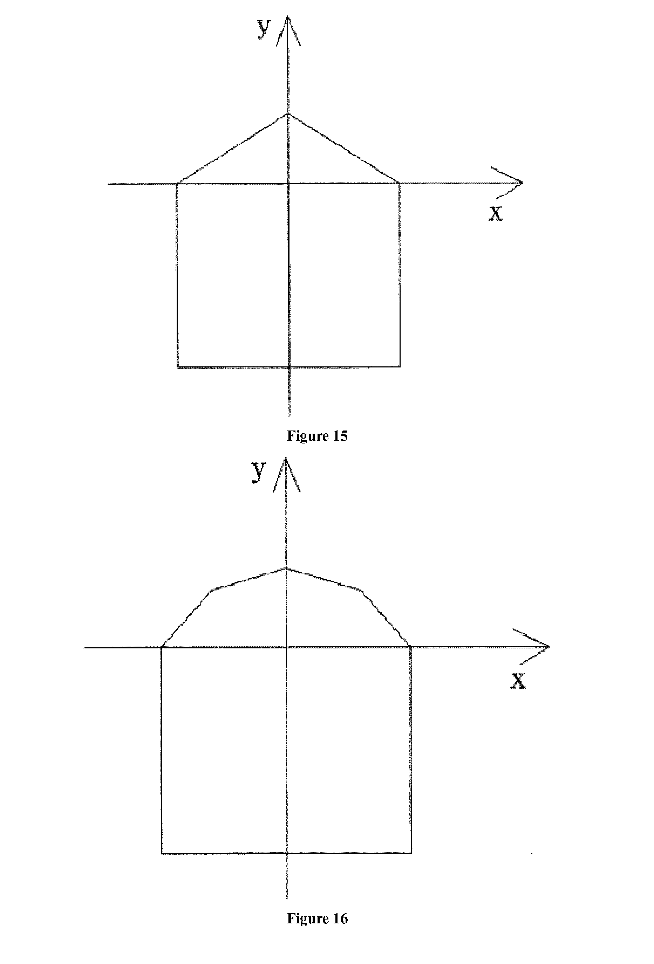

For example, when entry condition is a=3, b=0.5, h=7.5, n=l. 51893 respectively, two points can be calculated if $\triangle x$=3, with the coordinates being (3, 0) and (0, 3.267658). The curved surface formed by the obtained points symmetric with y axis is the shape as shown in Figure 15.

Three points can be calculated if $\triangle x$=1. 5, with the coordinates being (3, 0), (1.5, 1.633829) and (0, 2.245685). The curved surface formed by the obtained points symmetric with y axis is the shape as shown in Figure 16.

By analogy, the lens condensing and refracting surface of any polygonal structure can be obtained. The condition that $\triangle x$ shall meet is a/$\triangle x$=M, where M is any integer. When $\triangle x$ is small enough, a smooth curved linear arc-shaped condensation surface is obtained. In order to obtain transmittance as high as possible, $\triangle x$ is generally very small. Besides, 2000<a/$\triangle x$<10000 is taken to model and meet the processing requirements.

The vertical distance from the edge of the lens condensing and refracting surface to the lower flat surface of the linear condensation glass panel 1 is h, the lower end surface of the linear condensation glass panel 1 is accordingly connected with the upper end surface of the strip-shaped solar cell 6, and the linear condensation glass panel 1 is symmetric or asymmetric along the vertical central axis 9.

The linear condensation glass panel of the structure can reduce consumption of photovoltaic cell in the photovoltaic cell module and further reduce cost. Moreover, theoretical transmittance of a reflective cross-section of the linear condensation glass panel can reach at least 94%. Compared with the condensation photovoltaic module of Fresnel lens, the linear condensation glass panel can allow more rays to be absorbed by the solar cells. Light spots gathered by the linear condensation glass panel can be evenly distributed on the solar cells. Compared with common condensers, light spots are more even, which effectively reduces transverse current in the cell and improves photoelectric conversion efficiency.

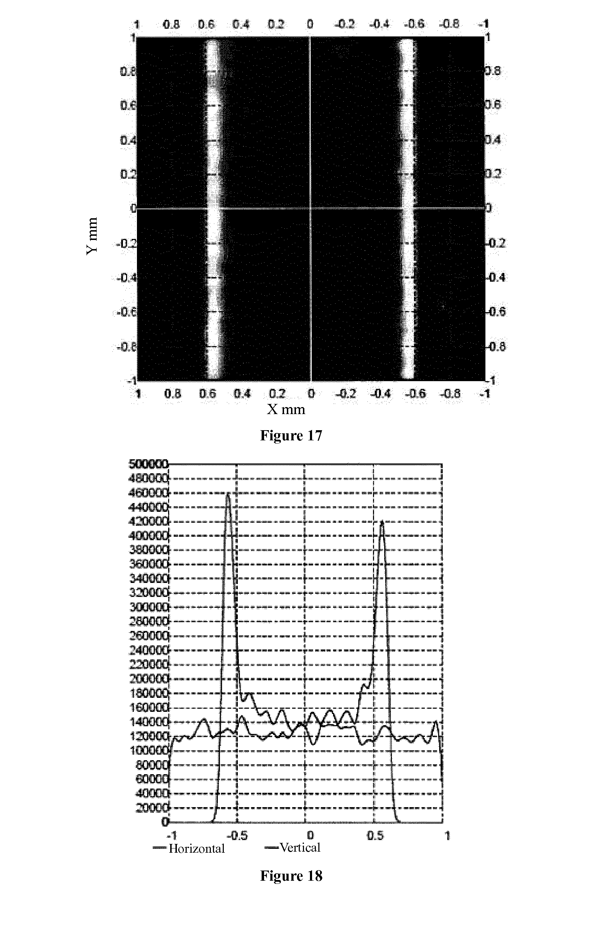

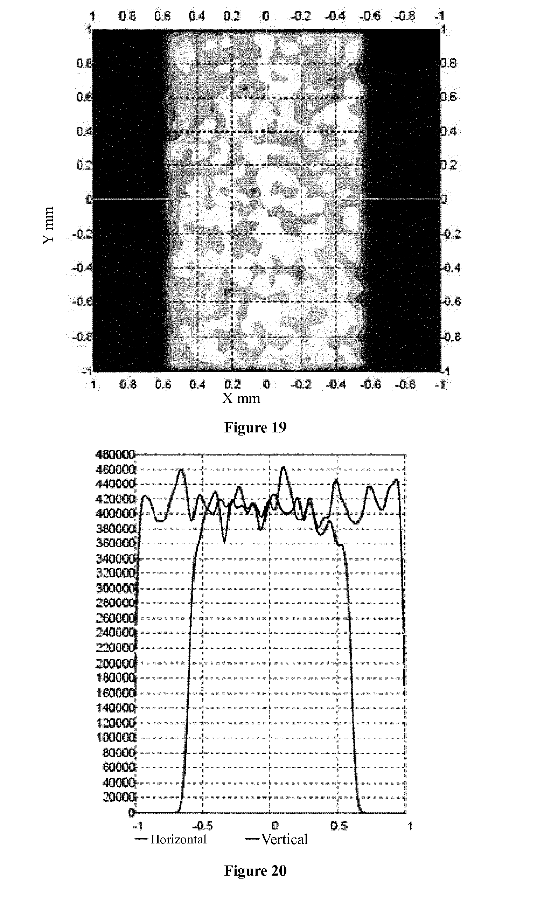

Figure 17 and Figure 18 are a power distribution diagram of light spots and a power distribution curve of light spots respectively after using a traditional lens as a condenser lens. In the power distribution diagram of light spots, edges at both sides of spot lights have the highest brightness and the center has relatively weak brightness. According to the power distribution curve of light spots, the peaks are at two sides of the curve and the brightness of its center decreases suddenly. As shown in Figure 17 and Figure 18, after using a traditional lens as a condenser lens, spot light energy is concentrated at edges of both sides and very unevenly distributed. Figure 19 and Figure 20 are a power distribution diagram of light spots and a power distribution curve of light spots respectively after using the linear condensation lens of the invention. In the power distribution diagram of light spots, the brightness of spot lights is basically uniform. According to the power distribution curve of light spots, the brightness is basically at the same energy level and energy is evenly distributed.

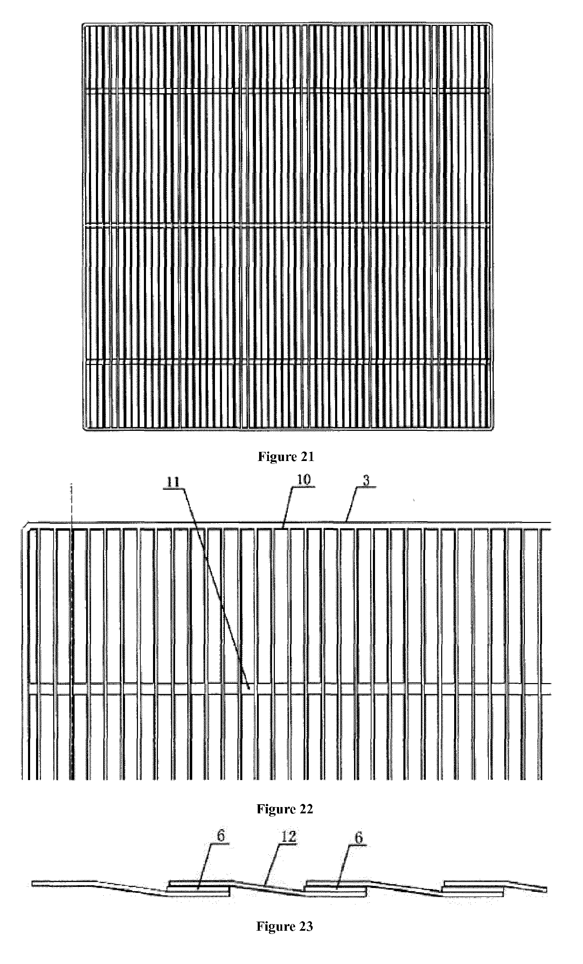

As shown in Figures 21 and 22, the surface of the solar cell 3 comprises multiple annular fine grid lines 10 equally spaced on the solar cell 3 and three main grid lines 11 perpendicular to the annular fine grid lines 10, the spacing between the two adjacent annular fine grid lines 10 is 0.1mm to 2mm, and each annual fine grid line 10 is 1mm to 10mm wide. The scribing position is at the clearance between the two adjacent annular fine grid lines 1, the scribing position is at the clearance between the two adjacent annular fine grid lines 10, the width of the annular fine grid lines 10 is less than that of cut strip-shaped solar cells, each annular fine grid line 10 corresponds to a strip-shaped solar cell, and the annular fine grid lines 10 are uniformly distributed at edges of corresponding strip-shaped solar cells; the annular fine grid lines 10 close to left and right edges on the solar cell 3 are of the same design and symmetrically arranged, and the annular fine grid lines 10 therebetween are of the same design and of rectangular shape.

The main grid lines 11 are disconnected at the clearance between two adjacent annular fine grid lines 10, and divided into multiple separate units matched with the annular fine grid lines 10. The front or rear main grid line is designed into disconnected separate units so that on the one hand, each whole cell piece is segmented into desired strip-shaped cells by laser or mechanical means because no metallic silver (front) or silver-aluminum alloy (rear) or other material can be used to form front and rear electrodes exists at the segmentation position, thus being capable of improving the processing efficiency, and effectively preventing edge breakage at cracking positions and other damages reducing cell efficiency. On the other hand, such design can also reduce the consumption of silver paste (front) and silver-aluminum paste (rear), thus reducing manufacturing cost.

The main grid lines 11 can be also of continuous design.

The design of grid lines on surfaces of linear condensation cells enables all strip-shaped cell units obtained from separation after cutting to have the same surface distribution, and the annular fine grid lines are uniformly distributed at edges of the strip-shaped cells, thus ensuring compatibility of electrical property of all strip-shaped cells. In addition, as the fine grid lines are distributed at edges of the cells, no grid line shields incident light when central areas of the strip-shaped cells are under high light intensity in medium and low condensation photovoltaic application, thus improving photoelectric conversion efficiency.

As shown in Figure 23, the grid solar cell pieces comprise multiple equally spaced strip-shaped solar cells 6, the strip-shaped solar cells 6 are electrically connected by solder strips 7 composed of multiple solder strip sections 12 connected between two adjacent strip-shaped solar cells 6, one end of each solder strip section 12 is connected to the upper end (i.e. negative pole) of one strip-shaped solar cell 6, and the other end is connected to the lower end (i.e. positive pole) of the other strip-shaped solar cell 6 connected thereto, the solder strip sections 12 are successively connected so that multiple strip-shaped solar cells 6 are electrically connected in series, and the solder strip sections 12 are of Z shape. This is one of series connection modes of strip-shaped solar cells, and the welding method and tools described in the step c) are used for parallel connection of strip-shaped solar cells.

The width of the finally formed grid cell pieces can be set at 125mm or 156mm as required so as to keep external dimensions of grid cell pieces consistent with those of common crystalline silicon solar cell pieces, thus being capable of carrying out subsequent processing on grid cell pieces by directly using automatic manufacturing equipment of common crystalline silicon assemblies. Certainly, the quantity and spacing of strip-shaped solar cells can be also adjusted freely according to specific needs.

Voltage of grid cell pieces formed by the means can reach several volts to tens of volts, thus meeting the requirements for use of some high voltage electrical appliances, and strip-shaped cells are arranged at certain intervals, therefore, such grid cell pieces have good light transmittance, and can be used as light transmitting members of building integrated photovoltaics. In addition, the grid cell pieces can be applied to low condensation assemblies by adding linear condensation panels on the grid cell pieces, thus being capable of effectively reducing the consumption of cell pieces as compared with a common panel assembly.

The above mentioned embodiments are only preferred embodiments of the invention rather than limitation to the invention. Any modification, equivalent replacement and improvement made within the scope of the spirit and rule of the invention can be incorporated in the protection scope of the invention.

**Claims**

1.  A manufacturing process of a linear condensation assembly, **characterized by** comprising the following processing steps:

    a) grading testing of cell pieces: grading power graded cell pieces based on the current value at the maximum power output thereof;

    b) cutting of the cell pieces: cutting crystalline silicon solar cells along the direction perpendicular to main grid lines of the cell pieces by laser or diamond to form strip-shaped solar cells;

    c) welding of the strip-shaped solar cells: arranging multiple solar cells cut into strips at certain intervals, and electrically connecting the solar cells by solder strips to form grid solar cell pieces;

d) series welding of the grid solar cell pieces: arranging multiple grid solar cell pieces formed in the step c) at certain intervals and welding the cell pieces to form cell strings;

e) stacking: successively stacking a linear condensation glass panel, a cell sealing material, the cell strings, the cell sealing material and a back panel material, and electrically connecting the cell strings of different grid shapes by a busbar; and

f) inspection and testing: visually inspecting the stacked linear condensation assembly, then carrying out EL testing, and finally carrying out subsequent procedures.

2. The manufacturing process of a linear condensation assembly of claim 1, **characterized in that** in the step b), the cutting of the solar cells is divided into scribing and segmenting, the solar cells are scribed by laser or diamond to form a 50 to 150$\mu$m depth on the solar cells, and then the solar cells are segmented along scribing positions by a segmenting device to form the strip-shaped solar cells.

3. The manufacturing process of a linear condensation assembly of claim 2, **characterized in that** in the step b), the back of the solar cells is scribed by laser or diamond, and then the solar cells are segmented along cutting positions by a segmenting device to form the strip-shaped solar cells.

4. The manufacturing process of a linear condensation assembly of claim 3, **characterized in that** the solar cell cut at a certain depth is placed on a soft rubber pad, with the side of the solar cell with scribing incision facing downward and the other side being provided with a layer of protective film; a scrollable rigid roller is placed on the protective film, and the rigid roller rolls along the direction perpendicular to the scribing direction of the solar cell; the solar cell pieces are rolled by the rigid roller and disconnected from the incision to form the strip-shaped solar cells; and after the solar cell pieces are broken into the strip-shaped solar cells, the protective film on the front of the solar cell is removed, and the strip-shaped solar cells are placed at certain intervals by a strip-shaped solar cell pickup device.

5. The manufacturing process of a linear condensation assembly of claim 3, **characterized in that** the solar cell cut at a certain depth is placed on a cell fixing platform with the back facing up, and fixed and adsorbed by negative pressure, a pneumatic clamping gripper arranged at the cell fixing platform clamps one side of the solar cell and inches the solar cell at a certain beat under the action of an inching drive mechanism; the other side of the solar cell is clamped at the clamping position of a segmenting mechanism, and the clamping position acts downward under the action of a segmenting cylinder to disconnect the solar cell along the scribing position and complete segmenting of the solar cell pieces; and the segmented strip-shaped solar cells are placed at certain intervals by the clamping position of the segmenting mechanism through a step motor.

6. The manufacturing process of a linear condensation assembly of claims 1 to 5, **characterized in that** in the step c), firstly, lower solder strips with the same number as the main grid lines of the welded strip-shaped solar cells are placed in a solder strip placement slot on a grid solar cell piece welding platform, vacuum adsorption holes arranged in the solder strip placement slot correspond to the lower solder strips, and the lower solder strips are fixed by adsorption; secondly, the strip-shaped solar cells cut as per the step b) are placed on the grid solar cell piece welding platform at a certain fixed interval, the upper end faces of the lower solder strips contact positive poles of the corresponding strip-shaped solar cells, the vacuum adsorption holes on the grid solar cell piece welding platform correspond to the placed strip-shaped solar cells, and the strip-shaped solar cells are fixed by adsorption; thirdly, upper solder strips are placed on negative main grid lines corresponding to the strip-shaped solar cells, an upper fire resistant hold-down mechanism moves downwards, and hold-down strips of the hold-down mechanism are used to compress the upper solder strips and the strip-shaped solar cells to allow close fit of the upper and lower solder strips and the strip-shaped solar cells during welding; and finally, an infrared soldering lamp moves downwards for infrared heating welding of welding positions of the solder strips and the strip-shaped solar cells through square holes arranged at the hold-down strips to form the grid solar cell pieces, for the grid solar cell pieces made by the welding method, the strip-shaped solar cells are interconnected in parallel, i.e. a positive pole is connected to a positive pole and a negative pole is connected to a negative pole.

7. The manufacturing process of a linear condensation assembly of claim 6, **characterized in that** in the step e), the linear condensation glass panel is properly placed, and a layer of cell sealing material is applied on the linear condensation glass panel, then the cell strings are placed, and a positioning device is used to align centers of the strip-shaped solar cells of the cell strings with optical construction centers of all curved linear condensation surfaces of the linear condensation glass panel, after alignment, a layer of cell sealing material and a layer of back panel material are successively applied.

8. The manufacturing process of a linear condensation assembly of claim 7, **characterized in that** the optical construction centers of the curved linear condensation surfaces of the linear condensation glass panel are identified by two position sensors, the position sensors move along optical structure surfaces of the curved linear condensation surfaces of the linear condensation glass panel to judge the highest points of the curved linear condensation surfaces, and then judge the center lines of the curved linear condensation surfaces, the strip-shaped solar cells move back and forth or left to right or rotate through strip-shaped cell position moving devices, and the strip-shaped cell position moving devices move accordingly based on central positions of the curved linear condensation surfaces of the linear condensation glass panel identified by the position sensors and deviation values to correct positions of the strip-shaped solar cells so that the centers are aligned with the optical construction centers of the curved linear condensation surfaces of the linear condensation glass panel.

9. The manufacturing process of a linear condensation assembly of claim 8, **characterized in that** the linear condensation glass panel gathers and projects solar rays received on the cell strings, width of linear condensing rays formed after the curved linear condensation surfaces of the linear condensation glass panel gather solar rays is not more than width of the strip-shaped solar cells in the cell strings, or the width of the linear condensing rays formed after the curved linear condensation surfaces of the linear condensation glass panel gather solar rays is not less than the width of the strip-shaped solar cells in the cell strings.

10. The manufacturing process of a linear condensation assembly of claim 9, **characterized in that** the width of the linear condensing rays formed after the curved linear condensation surfaces of the linear condensation glass panel gather solar rays is consistent with the width of the strip-shaped solar cells in the cell strings, and the spacing between the two adjacent strip-shaped solar cells is consistent with the spacing between the linear condensing rays formed by adjacent curved linear condensation surfaces.

11. The manufacturing process of a linear condensation assembly of claim 10, **characterized in that** receiving surfaces on upper surfaces of the strip-shaped solar cells of the grid solar cell pieces are on the same plane, the receiving surfaces formed by upper surfaces of the grid solar cell pieces in the cell strings are on the same plane, and the receiving surfaces formed by upper surfaces of the cell strings are on the same plane.

12. A linear condensation assembly, comprising a linear condensation glass panel (1), a sealing material layer (2), solar cells (3) and a back panel (4), the upper part of the condensation glass panel (1) being of a curved linear arc-shaped condensation surface array, the solar cells (3) comprising multiple strip-shaped solar cells (6) and solder strips (7), the strip-shaped solar cells (6) vertically corresponding to curved linear arc-shaped condensation surfaces of the linear condensation glass panel (1), the multiple strip-shaped solar cells (6) being welded and connected on the solder strips (7) to form grid solar cell pieces, and the linear condensation glass panel (1), the sealing material layer (2), the solar cells (3) and the back panel (4) being laminated to form a linear condensation assembly.

13. The linear condensation assembly of claim 12, **characterized in that** an upper end surface of the linear condensation glass panel (1) is a lens condensing and refracting surface, and a lower end thereof is a flat surface, the lens extends transversally and is of strip shape, the linear condensation glass panel (1) is capable of refracting mutually parallel incident rays onto the grid solar cell pieces arranged below the linear condensation glass panel (1) so as to form linear condensation rays; if the vertical distance from a contact point between any incident ray (8) and the lens condensing and refracting surface to corresponding vertical central axis (9) of the lens on the linear condensation glass panel (1) is x, the vertical distance from a projection point formed after the incident ray (8) is refracted onto the corresponding strip-shaped solar cell (6) through the lens to the center line in the length direction of the linear condensation ray is m, the vertical distance from the edge of the lens condensing and refracting surface to the vertical central axis (9) is a, and the vertical distance from the projection point of the incident ray refracted through the edge of the lens condensing and refracting surface on the strip-shaped solar cell (6) to the center line in the length direction of the linear condensation ray is b, the condition that the lens meets is x/m=a/b, wherein, a vertical surface composed of an incidence point of the incident ray (8) and two edges of the lens condensing and refracting surface is perpendicular to the center line in the length direction of the linear condensation ray; the upper part of the vertical surface is the contour shape of the lens condensing and refracting surface, an incidence angle at which the incident ray (8) passes through the lens condensing and refracting surface is $\beta$, and a refraction angle is $\theta$; an included angle between the incident ray (8) refracted and the strip-shaped solar cell (6) is $\alpha$, the vertical distance from the lens condensing and refracting surface to the strip-shaped solar cell (6) is h, in the vertical surface, a plane coordinate system is composed of the vertical central axis (9) and a connecting line between two edges of the lens condensing and refracting surface; and with the middle point of the connecting line between two edges of the lens condensing and refracting surface as the origin of coordinate, a curve equation of the contour shape of the lens condensing and refracting surface on the vertical surface in the plane coordinate system is obtained from following formulas:

$$\text{formula 1: } x/m=a/b, \ x=a-N*\triangle x,$$

where $\triangle x$ is a very small distance in the direction of X axis, and N is the number of the small intervals;

$$\text{formula 2: } y_n=y_{n-1}+\triangle x*\tan \beta;$$

$$\text{formula 3: } \tan \alpha = (h+y_n) \, / \, (a-m), \ m=b-N*\triangle x*b/a;$$

$$\text{formula 4: } \sin \beta=n*\sin\theta,$$

where coefficient n is refractive index of the lens;

$$\text{formula 5: } \alpha-\theta+\beta= \pi/2,$$

that is, $\theta = (\alpha+\beta) -\pi/2$;

$$\text{formula 6: } \sin \beta=n*\sin[ (\alpha+\beta) -\pi/2]= n*[-\cos (\alpha+\beta) ]=n* (\sin \alpha*\sin \beta-\cos \alpha*\cos \beta);$$

and

$$\text{formula 7: } \tan \beta=n*\cos \alpha/ (n*\sin \alpha-1);$$

where, a, b, h, n and $\triangle x$ are known, and $y_0$ is equal to 0; variable x is the transversal distance from any point on the lens condensing and refracting surface to the vertical central axis (9) on the vertical surface, and variable y is the vertical distance from the point to the plane where both edges of the lens condensing and refracting surface are located.

14. The linear condensation assembly of claim 13, **characterized in that** the contour shape of the lens condensing and refracting surface on the vertical surface is a polygon, as value of $\triangle x$ decreases, the edges of the polygon of the lens condensing and refracting surface increase till a smooth curved linear arc-shaped condensation surface is formed, where condition that $\triangle x$ shall meet is $a/\triangle x=M$, M is any integer, and $2000<a/\triangle x<10000$.

15. The linear condensation assembly of claim 14, **characterized in that** the vertical distance a from the edge of the lens condensing and refracting surface to the vertical central axis (9) and the vertical distance b from the projection point of the incident ray (8) refracted through the lens condensing and refracting surface on the strip-shaped solar cell to the center line in the length direction of the linear condensation ray meet the following condition: $1<a/b\leq10$.

16. The linear condensation assembly of claim 15, **characterized in that** the vertical distance from the edge of the lens condensing and refracting surface to the lower flat surface of the linear condensation glass panel (1) is h, and the lower end surface of the linear condensation glass panel (1) is accordingly connected with the upper end surface of the strip-shaped solar cell (6).

**17.** The linear condensation assembly of claim 16, **characterized in that** the linear condensation glass panel (1) is symmetrical or asymmetrical along the vertical central axis (9).

**18.** The linear condensation assembly of claim 12, **characterized in that** the surface of the solar cell (3) comprises multiple annular fine grid lines (10) equally spaced on the solar cell (3) and at least two main grid lines (11) perpendicular to the annular fine grid lines (10), the spacing between the two adjacent annular fine grid lines (10) is 0.1mm to 2mm, and each annual fine grid line (10) is 1mm to 10mm wide.

**19.** The linear condensation assembly of claim 18, **characterized in that** the main grid lines (11) are disconnected at the clearance between two annular fine grid lines (10), and are divided into multiple separate units matched with the annular fine grid lines (10).

**20.** The linear condensation assembly of claim 18 or 19, **characterized in that** the scribing position is at the clearance between the two adjacent annular fine grid lines (10), the width of the annular fine grid lines (10) is less than that of the cut strip-shaped solar cells, each annular fine grid line (10) corresponds to a strip-shaped solar cell, and the annular fine grid lines (10) are uniformly distributed at edges of the corresponding strip-shaped solar cells.

**21.** The linear condensation assembly of claim 20, **characterized in that** annular fine grid lines (10) close to left and right edges on the solar cell (3) are of the same design and symmetrically arranged, and the annular fine grid lines (10) therebetween are of the same design and of rectangular shape.

**22.** The linear condensation assembly of claim 12, **characterized in that** the grid solar cell pieces comprise multiple equally spaced strip-shaped solar cells (6), the strip-shaped solar cells (6) are electrically connected by solder strips (7) composed of multiple solder strip sections (12) connected between two adjacent strip-shaped solar cells (6), one end of each solder strip section (12) is connected to the upper end of one strip-shaped solar cell (6), and the other end is connected to the lower end of the other strip-shaped solar cell (6) connected thereto, and the solder strip sections (12) are successively connected so that multiple strip-shaped solar cells (6) are electrically connected in series.

**23.** The linear condensation assembly of claim 22, **characterized in that** the solder strip sections (12) are of Z shape.

3

Figure 1

15

14    3    13

Figure 2

20

3

18    17    16    19

Figure 3

**Figure 4**

**Figure 5**

Figure 6

Figure 7

Figure 8

Figure 9

Figure 10

**Figure 11**

**Figure 12**

Figure 13

Figure 14

Figure 15

Figure 16

Figure 17

—Horizontal    —Vertical

Figure 18

Figure 19

Figure 20

**Figure 21**

**Figure 22**

**Figure 23**

# INTERNATIONAL SEARCH REPORT

| International application No. |
|---|
| **PCT/CN2013/085139** |

## A. CLASSIFICATION OF SUBJECT MATTER

See the extra sheet

According to International Patent Classification (IPC) or to both national classification and IPC

## B. FIELDS SEARCHED

Minimum documentation searched (classification system followed by classification symbols)

IPC: H01L, G02B

Documentation searched other than minimum documentation to the extent that such documents are included in the fields searched

Electronic data base consulted during the international search (name of data base and, where practicable, search terms used)

WPL, EPODOC, CNKI, CNPAT: solar energy, sun, layer, overlay, cut, condensation, solar, cell, battery, strip, grid, scrib+

## C. DOCUMENTS CONSIDERED TO BE RELEVANT

| Category* | Citation of document, with indication, where appropriate, of the relevant passages | Relevant to claim No. |
|---|---|---|
| X | CN 102386266 A (CHENGDU ZSUN SCIENCE AND TECHNOLOGY DEVELOPING CO., LTD.), 21 March 2012 (21.03.2012), description, paragraphs (0006)-(0015), and figures 1-4 | 12 |
| PX | CN 103178160 A (SICHUAN ZSUN SOLAR ENERGY DEVELOPMENT CO., LTD.), 26 June 2013 (26.06.2013), the whole document | 1-4, 2-15 |
| PX | | 16-17 |
| PX | CN 103022205 A (CHENGDU ZSUN SCIENCE AND TECHNOLOGY DEVELOPING CO., LTD.), 03 April 2013 (03.04.2013), the whole document | 16-17 |
| PX | CN 203179925 U (SICHUAN ZSUN SOLAR ENERGY DEVELOPMENT CO., LTD.), 04 September 2013 (04.09.2013), the whole document | 16-17 |
| A | US 2011017263 A1 (GIBSON et al.), 27 January 2011 (27.01.2011), the whole document | 1-23 |
| A | CN 101943765 B (CHENGDU ZSUN SCIENCE AND TECHNOLOGY DEVELOPING CO., LTD.), 16 November 2011 (16.11.2011), the whole document | 1-23 |
| A | US 4419530 A (NATH), 06 December 1983 (06.12.1983), the whole document | 1-23 |

☐ Further documents are listed in the continuation of Box C.  ☒ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 08 January 2014 (08.01.2014) | **23 January 2014 (23.01.2014)** |

| Name and mailing address of the ISA/CN:<br>State Intellectual Property Office of the P. R. China<br>No. 6, Xitucheng Road, Jimenqiao<br>Haidian District, Beijing 100088, China<br>Facsimile No.: (86-10) 62019451 | Authorized officer<br><br>**WANG, Lei**<br><br>Telephone No.: (86-10) **62411577** |

Form PCT/ISA/210 (second sheet) (July 2009)

## INTERNATIONAL SEARCH REPORT
### Information on patent family members

International application No.

**PCT/CN2013/085139**

| Patent Documents referred in the Report | Publication Date | Patent Family | Publication Date |
|---|---|---|---|
| CN 102386266 A | 21.03.2012 | None | |
| CN 103178160 A | 26.06.2013 | None | |
| CN 103022205 A | 03.04.2013 | None | |
| CN 203179925 U | 04.09.2013 | None | |
| US 2011017263 A1 | 27.01.2011 | None | |
| CN 101943765 B | 16.11.2011 | CN 101943765 A | 12.01.2011 |
| | | EP 2610649 A1 | 03.07.2013 |
| | | WO 2012025019 A1 | 01.03.2012 |
| | | AU 2011295603 A1 | 08.11.2012 |
| | | US 2013139867 A1 | 06.06.2013 |
| US 4419530 A | 06.12.1983 | GB 2114815 A | 24.08.1983 |
| | | GB 2114815 B | 23.04.1986 |
| | | DE 3303312 A1 | 01.09.1983 |
| | | FR 2521351 A1 | 12.08.1983 |
| | | JPS 58194379 A | 12.11.1983 |
| | | JPH 0413869 B2 | 11.03.1992 |
| | | NL 8300463 A | 01.09.1983 |
| | | AU 1062483 A | 18.08.1983 |
| | | SE 8300606 A | 12.08.1983 |
| | | SE 8300606 L | 12.08.1983 |
| | | BR 8300515 A | 08.11.1983 |
| | | ZA 8300537 A | 25.04.1984 |
| | | CA 1186786 A1 | 07.05.1985 |
| | | CH 655614 B | 30.04.1986 |
| | | IL 67853 A | 29.04.1986 |
| | | JPS 63232376 A | 28.09.1988 |
| | | JPH 0695577 B2 | 24.11.1994 |
| | | SE 457299 B | 12.12.1988 |
| | | SE 457299 C | 13.04.1989 |
| | | IT 1171053 B | 10.06.1987 |
| | | AU 556166 B2 | 23.10.1986 |
| | | IE 54443 B1 | 11.10.1989 |
| | | IE 830237 L | 11.08.1983 |
| | | IN 157875 A1 | 12.07.1986 |
| | | KR 910001875 B1 | 28.03.1991 |
| | | MX 153561 A | 14.11.1986 |
| | | PH 19748 A | 23.06.1986 |

Form PCT/ISA/210 (patent family annex) (July 2009)

# INTERNATIONAL SEARCH REPORT

International application No.

**PCT/CN2013/085139**

**CONTINUATION OF SECOND SHEET    A. CLASSIFICATION OF SUBJECT MATTER**

H01L 31/18 (2006.01) i

H01L 31/052 (2014.01) i

H01L 31/0224 (2006.01) i

G02B 3/00 (2006.01) i

Form PCT/ISA/210 (extra sheet) (July 2009)